(19) Europäisches Patentamt
European Patent Office
Office européen des brevets

(11) **EP 1 647 091 B1**

(12) **FASCICULE DE BREVET EUROPEEN**

(45) Date de publication et mention
de la délivrance du brevet:
**28.05.2008 Bulletin 2008/22**

(51) Int Cl.:
*H03F 3/193* (2006.01)    *H03F 3/345* (2006.01)
*H03F 1/30* (2006.01)    *H03K 5/02* (2006.01)

(21) Numéro de dépôt: **04767891.7**

(22) Date de dépôt: **13.07.2004**

(86) Numéro de dépôt international:
**PCT/FR2004/050330**

(87) Numéro de publication internationale:
**WO 2005/011104 (03.02.2005 Gazette 2005/05)**

(54) **AMPLIFICATEUR DE TENSION A FAIBLE CONSOMMATION**

SPANNUNGSVERSTÄRKER MIT NIEDRIGEM VERBRAUCH

LOW-CONSUMPTION VOLTAGE AMPLIFIER

(84) Etats contractants désignés:
**AT BE BG CH CY CZ DE DK EE ES FI FR GB GR
HU IE IT LI LU MC NL PL PT RO SE SI SK TR**

(30) Priorité: **17.07.2003 FR 0350344**

(43) Date de publication de la demande:
**19.04.2006 Bulletin 2006/16**

(73) Titulaire: **COMMISSARIAT A L'ENERGIE
ATOMIQUE
75015 Paris (FR)**

(72) Inventeur: **ARQUES, Marc
F-38100 Grenoble (FR)**

(74) Mandataire: **Poulin, Gérard
Brevatome
3, rue du Docteur Lancereaux
75008 Paris (FR)**

(56) Documents cités:
**EP-A- 0 480 815        EP-A- 0 789 450
WO-A-03/034593        US-A- 3 733 514**

**Description**

**DOMAINE TECHNIQUE ET ART ANTERIEUR**

L'invention concerne un amplificateur de tension à faible consommation.

L'amplificateur de tension à faible consommation selon l'invention peut être utilisé dans tout domaine de l'Electronique. Selon une application particulièrement avantageuse, l'amplificateur de tension à faible consommation selon l'invention est un amplificateur tension/tension de détecteur de photons X ou gamma.

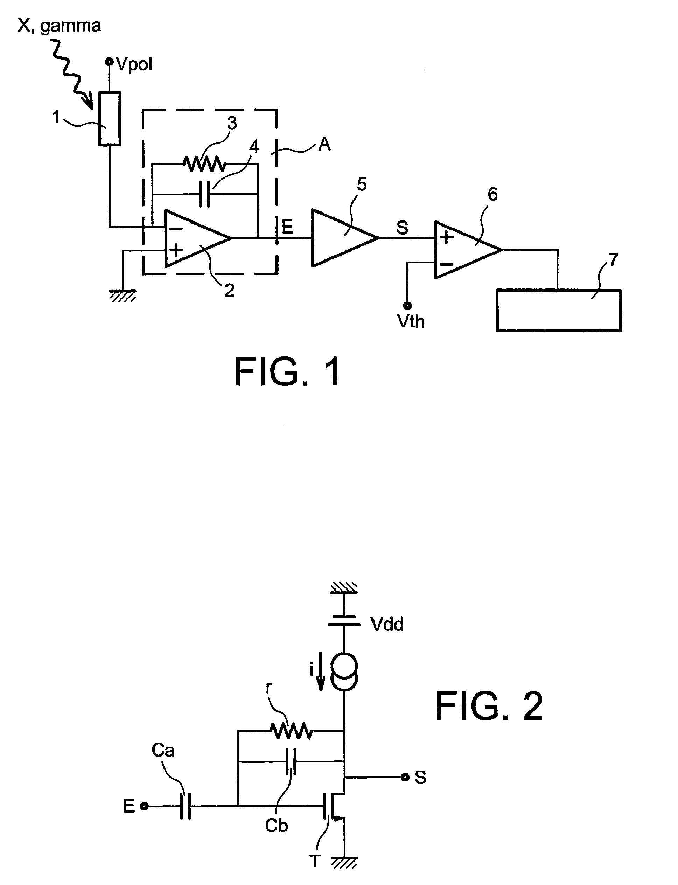

Le schéma de principe d'un détecteur de photons X ou gamma fonctionnant en comptage de photons est représenté en figure 1. Le détecteur comprend un détecteur élémentaire 1, polarisé par une tension Vpol, qui transforme chaque photon détecté en une impulsion de courant, un amplificateur charge/tension A qui intègre le courant délivré par le détecteur élémentaire pendant la durée de l'impulsion et transforme la charge obtenue en une tension, un amplificateur tension/tension 5 qui amplifie le signal délivré par l'amplificateur charge/tension et limite la bande passante de ce signal afin de réduire le bruit du détecteur, un comparateur 6 qui compare la tension délivrée par l'amplificateur 5 avec une tension de seuil Vth et un compteur 7.

L'amplificateur A est généralement constitué d'un amplificateur opérationnel 2 dont l'entrée inverseuse (-) est reliée au détecteur élémentaire 1 et dont l'entrée non inverseuse (+) est reliée à la masse du circuit, une résistance 3 et un condensateur 4 étant montés en parallèle entre l'entrée inverseuse (-) et la sortie de l'amplificateur opérationnel 2.

De façon générale, les performances demandées à l'amplificateur tension/tension 5 sont les suivantes :

-   être capable de traiter des flux d'impulsions rapides (par exemple, plusieurs millions d'impulsions par seconde) ;
-   être faible bruit ;
-   consommer peu ;
-   avoir une impédance d'entrée élevée (de façon à pouvoir être attaqué par l'amplificateur charge/tension situé en amont dont l'impédance de sortie est élevée) ;
-   être réalisable en circuit intégré afin d'être peu encombrant ;
-   s'adapter au niveau de la tension de repos de l'amplificateur charge/tension situé en amont, qui peut ne pas être bien établi du fait de variations du courant de repos du détecteur élémentaire ou de dispersions technologiques.

La figure 2 représente un amplificateur tension/tension 5 de l'art connu. L'amplificateur comprend un transistor MOS T (MOS pour « Metal Oxide Semiconductor »), un premier condensateur de capacité Ca ayant une première armature reliée à la grille du transistor T, un deuxième condensateur de capacité Cb monté entre la grille et le drain du transistor T, une résistance r montée en parallèle du deuxième condensateur de capacité Cb et un générateur de courant i monté entre une tension d'alimentation Vdd et le drain du transistor T dont la source est reliée à la masse. L'entrée E de l'amplificateur est constituée par la deuxième armature du premier condensateur de capacité Ca et la sortie S de l'amplificateur par le drain du transistor T. Le gain nominal G de l'amplificateur s'écrit alors :

$$G = - \ Ca/Cb$$

La résistance r permet, d'une part, de stabiliser le potentiel sur la grille du transistor T, et, d'autre part, de régler la fréquence de coupure basse du circuit.

Un tel amplificateur présente plusieurs limitations. En particulier, la contre-réaction (r, Cb) conduit la grille du transistor T à apparaître, en alternatif, comme une masse virtuelle pour l'étage situé en amont. La recherche d'un gain élevé, et donc d'une valeur de capacité Ca élevée, conduit alors à charger l'étage situé en amont et, partant, à faire consommer ce dernier de façon importante. La consommation globale de l'amplificateur peut alors devenir importante et atteindre plusieurs dizaines, voire plusieurs centaines, de microwatts.

L'amplificateur selon invention ne présente pas cet inconvénient.

Un autre amplificateur de l'art connu est décrit dans le document EP-A-0789450.

**EXPOSE DE L'INVENTION**

En effet, l'invention concerne un amplificateur de tension comprenant un premier transistor à effet de champ ayant une grille, un drain et une source, la borne d'entrée et la borne sortie de l'amplificateur étant formées respectivement par la grille et par le drain du premier transistor à effet de champ. L'amplificateur de tension comprend :

-   un premier générateur de courant qui charge le drain du premier transistor ;
-   un deuxième générateur de courant qui charge la source du premier transistor, la valeur du courant délivré par le deuxième générateur de courant étant sensiblement égale à la valeur du courant délivré par le premier générateur de courant ;
-   un premier condensateur ayant une première borne reliée au drain du premier transistor et une deuxième borne reliée à une première tension de référence ;
-   un deuxième condensateur ayant une première borne reliée à la source du premier transistor et une deuxième borne reliée à une deuxième tension de référence ; et

- un transistor à effet de champ supplémentaire de type opposé au premier transistor à effet de champ, le drain du transistor supplémentaire étant relié au drain du premier transistor à effet de champ, la grille du transistor supplémentaire étant reliée à une tension décalée ou non décalée par rapport à la tension appliquée sur la grille du premier transistor à effet de champ, la source du transistor à effet de champ supplémentaire étant reliée au premier générateur de courant et à une première borne d'un condensateur supplémentaire dont la deuxième borne est reliée à une tension fixe.

Les première et deuxième tensions de référence peuvent être une même tension, par exemple, la tension de référence du circuit (masse).

Selon une caractéristique supplémentaire de l'invention, l'amplificateur comprend un circuit d'asservissement de la tension de sortie qu'il délivre.

Selon encore une caractéristique supplémentaire de l'invention, le circuit d'asservissement est constitué d'une résistance connectée entre le drain du premier transistor et une tension fixe.

Selon encore une caractéristique supplémentaire de l'invention, le circuit d'asservissement est constitué d'un circuit de lecture dont l'entrée reçoit la tension de sortie de l'amplificateur et dont la sortie délivre un signal de commande de la grille d'un transistor qui constitue le premier ou le second générateur de courant.

Selon encore une caractéristique supplémentaire de l'invention, l'amplificateur comprend un filtre passe-bas placé en sortie du circuit de lecture pour filtrer le signal de commande délivré par le circuit de lecture.

Selon encore une caractéristique supplémentaire de l'invention, le circuit de lecture est un suiveur de tension.

Selon encore une caractéristique supplémentaire de l'invention, le circuit de lecture est un amplificateur différentiel à deux entrées, la tension de sortie de l'amplificateur étant appliquée sur une première entrée de l'amplificateur différentiel et une tension de référence étant appliquée sur la deuxième entrée de l'amplificateur différentiel.

Selon encore une caractéristique supplémentaire de l'invention, le circuit de lecture est un amplificateur qui amplifie les variations de la tension de sortie de l'amplificateur par rapport à une tension de référence déterminée à partir d'une tension de réglage.

Selon encore une caractéristique supplémentaire de l'invention, le circuit d'asservissement est constitué d'un transistor MOS monté en grille commune et dont la source est connectée à la sortie de l'amplificateur.

Selon un premier mode de réalisation de l'invention, la grille du premier transistor à effet de champ et la grille du transistor supplémentaire sont reliées entre elles.

Selon un deuxième mode de réalisation de l'invention, l'amplificateur comprend un circuit de décalage de tension pour former la tension appliquée sur la grille du transistor supplémentaire à partir de la tension appliquée sur la grille du premier transistor à effet de champ.

Selon encore une caractéristique supplémentaire de l'invention, le circuit de décalage de tension est une source de tension extérieure.

Selon encore une caractéristique supplémentaire de l'invention, le circuit de décalage de tension est une diode polarisée en direct.

Selon encore une caractéristique supplémentaire de l'invention, l'amplificateur est réalisé en technologie MOS.

L'invention concerne également un détecteur de photons X ou gamma comprenant un amplificateur charge/tension et un amplificateur tension/tension qui amplifie la tension délivrée par l'amplificateur charge/tension, caractérisé en ce que l'amplificateur tension/tension est un amplificateur selon l'invention.

## BREVE DESCRIPTION DES FIGURES

D'autres caractéristiques et avantages de l'invention apparaîtront à la lecture de modes de réalisation préférentiels de l'invention faits en référence aux figures jointes parmi lesquelles :

- la figure 1 représente un schéma de principe de détecteur de photons X ou gamma selon l'art connu ;
- la figure 2 représente un schéma électrique d'amplificateur tension/tension de détecteur de photons X ou gamma selon l'art connu ;
- la figure 3 représente un schéma électrique d'amplificateur tension/tension ;
- les figures 4A, 4B, 5A et 5B représentent différentes variantes d'un perfectionnement d'amplificateur tension/tension ;
- la figure 6 représente un amplificateur tension/tension selon un premier mode de réalisation de l'invention ;
- la figure 7 représente un amplificateur tension/tension selon un deuxième mode de réalisation de l'invention ;
- la figure 8 représente un perfectionnement de l'amplificateur tension/tension représenté en figure 6 ;
- la figure 9 représente un exemple de réalisation d'amplificateur tension/tension selon l'invention.

Sur toutes les figures, les mêmes références désignent les mêmes éléments.

## DESCRIPTION DETAILLEE DE MODES DE MISES EN OEUVRE DE L'INVENTION

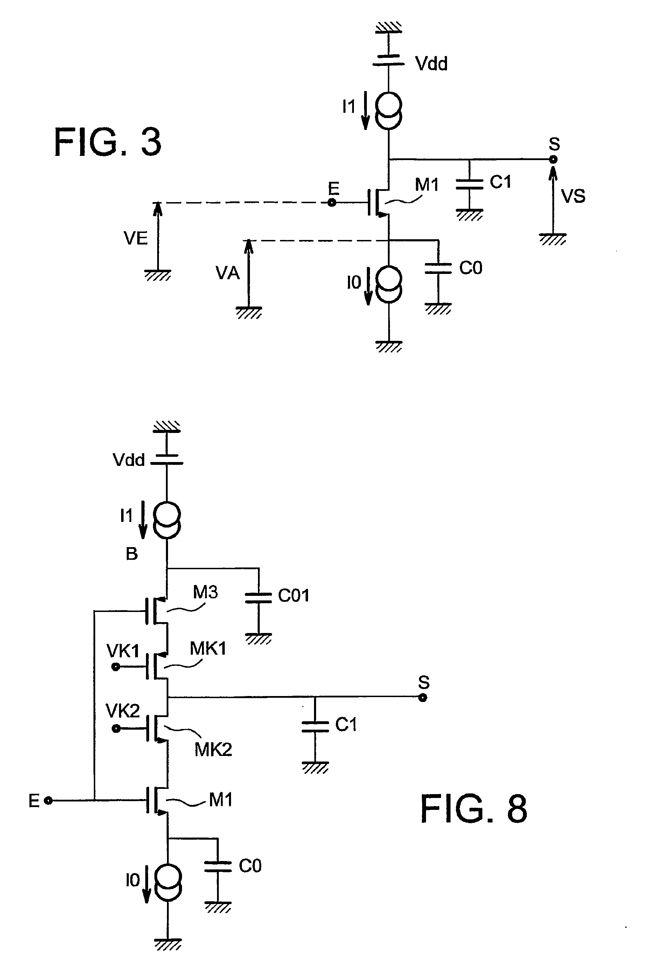

La figure 3 représente un schéma électrique d'un amplificateur tension/tension.

L'amplificateur tension/tension comprend un transistor MOS M1, un premier générateur de courant I1, un premier condensateur de capacité C1, un deuxième générateur de courant I0 et un deuxième condensateur de capacité C0. Le montage est décrit, à titre d'exemple, avec un transistor MOS de type N. L'homme de l'art peut transposer ce montage sans effort avec un transistor MOS de type P.

L'amplificateur est alimenté entre une tension de polarisation Vdd et une tension de référence, par exemple la masse. La borne d'entrée E et la borne de sortie S de l'amplificateur sont respectivement la grille et le drain du transistor M1.

Le drain du transistor est relié à une première borne du premier générateur de courant I1 dont la deuxième borne est reliée à la tension d'alimentation Vdd. Le premier condensateur de capacité C1 a une première borne reliée au drain du transistor M1 et une deuxième borne reliée à la masse. La source du transistor M1 est reliée à une première borne du deuxième générateur de courant I0 dont la deuxième borne est reliée à la masse. Le deuxième condensateur de capacité C0 est monté en parallèle du deuxième générateur de courant I0.

Le fonctionnement de l'amplificateur va maintenant être décrit.

Au départ, le transistor M1 ne conduit pas. Le générateur de courant I0 injecte des électrons sur la source du transistor M1, lesquels électrons sont stockés dans le condensateur de capacité C0, entraînant la chute du potentiel de source VA, jusqu'à ce que le transistor M1 se mette à conduire. Le potentiel de source VA se stabilise lorsque le courant qui parcourt le transistor M1 devient égal à I0. Tant que le transistor M1 ne conduit pas, la tension de sortie VS de l'amplificateur est égale à la tension d'alimentation Vdd. A partir du moment où le transistor M1 conduit le courant I0, si les courants I1 et I0 sont sensiblement égaux, la borne de sortie S reçoit une somme de courants nulle et la tension de sortie VS peut a priori se stabiliser à une valeur quelconque entre VE-VT et Vdd, où VE est la tension d'entrée de l'amplificateur et VT la tension de seuil du transistor M1.

Supposons la tension de sortie VS égale à une tension de repos VS0. Si l'étage en amont de l'amplificateur module la tension d'entrée VE d'une quantité ΔVE positive, alors le transistor M1 conduit temporairement davantage et le potentiel VA croît jusqu'à ce que le courant qui parcourt le transistor M1 se stabilise de nouveau à la valeur I0. Il vient alors :

$$VA \approx VE-VT + \Delta VE.$$

La charge Q01 transmise par le transistor M1, de la source vers le drain du transistor M1, pendant la durée Δt1 du phénomène transitoire décrit ci-dessus s'écrit alors :

$$Q01 = -I0 \times \Delta t1 - C0 \times \Delta VE$$

Pendant cette même durée Δt1, la charge Q1 délivrée par le générateur de courant I1 sur la borne de sortie S s'écrit :

$$Q1 = I1 \times \Delta t1,$$

soit

$$Q1 \cong I0 \times \Delta t1$$

La variation de charge ΔQ1 sur la borne de sortie S s'écrit alors :

$$\Delta Q1 \cong - C0 \times \Delta VE,$$

ce qui génère une variation de tension telle que :

$$\Delta VS \cong - (C0/C1) \times \Delta VE.$$

Pendant la durée du transitoire où apparaît la tension ΔVE, l'amplificateur présente ainsi un gain négatif égal à - (C0/C1). Un échelon d'entrée est alors transformé en un échelon de sortie.

Lorsque la tension VE revient à son état de repos, et donc varie d'une quantité ΔVE négative, le transistor M1 conduit temporairement moins. La tension VA diminue jusqu'à ce que le courant qui parcourt le transistor se stabilise de nouveau à la valeur I0. La tension VA s'écrit alors :

$$VA \cong VE - VT.$$

La charge Q02 transmise par le transistor M1, de la source vers le drain, pendant la durée Δt2 de ce phénomène transitoire s'écrit alors :

$$Q02 = - I0 \times \Delta t2 + C0 \times \Delta VE$$

Pendant ce même temps Δt2, la charge Q2 délivrée par le générateur de courant I0 sur la borne de sortie S s'écrit :

$$Q2 = I1 \times \Delta t2,$$

soit

$$Q2 \cong I0 \times \Delta t2$$

La variation de charge $\Delta Q2$ sur la borne S s'écrit donc :

$$\Delta Q2 \cong C0 \times \Delta VE$$

ce qui génère une variation de tension $\Delta Vs$ telle que :

$$\Delta VS \cong (C0 /C1) \times \Delta VE$$

Cette variation étant l'opposé de la variation précédente, la tension de sortie VS revient à sa valeur de repos.

L'amplificateur de tension proposé est un amplificateur de tension de gain négatif -(C0/C1).

Les principaux avantages d'un tel circuit peuvent être énumérés comme suit :

- l'étage situé en amont de l'amplificateur ne voit comme charge que la faible capacité de grille du transistor M1,
- si la valeur de repos de la tension d'entrée VE varie, cela change le point d'équilibre de la source du transistor M1 (VA = VE - VT) et, partant, cela change l'excursion de tension possible pour la tension de sortie VS (de VA à Vdd), alors que cela ne change ni la valeur de repos de la tension de sortie VS, ni le gain du montage.

La tension VS disponible en sortie de l'amplificateur est délivrée sous haute impédance. Cela nécessite donc que l'étage aval soit lui-même un étage à haute impédance. Ceci est facilement réalisable à l'aide de circuits intégrés, en particulier de circuits intégrés MOS pour lesquels l'impédance d'entrée de l'étage aval peut être purement capacitive et élevée du fait de la faible taille des transistors (faible capacité de grille). Il faut également noter qu'à la capacité de sortie C1 s'ajoute la capacité parasite de liaison entre l'amplificateur et l'étage aval. Là encore, des circuits intégrés permettent de minimiser les capacités parasites.

Il est souhaitable de réaliser une égalité des courants I0 et I1 de façon aussi précise que possible, afin que la tension VS puisse se stabiliser entre la tension VE - VT et la tension Vdd. Du fait des dispersions technologiques, une égalité quasi-parfaite entre I0 et I1 ne peut généralement pas être obtenue par simple dimensionnement des composants qui constituent le circuit. L'égalité quasi-parfaite entre I0 et I1 est alors obtenue à l'aide d'un dispositif d'asservissement.

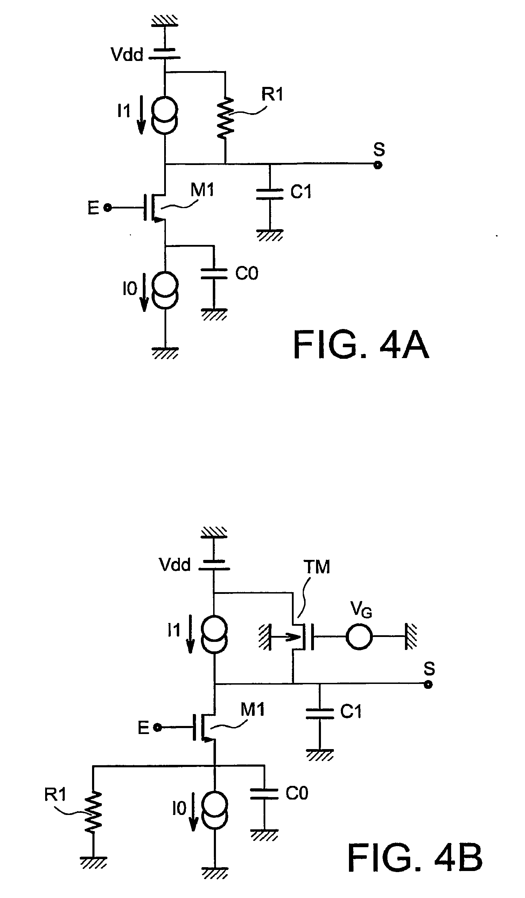

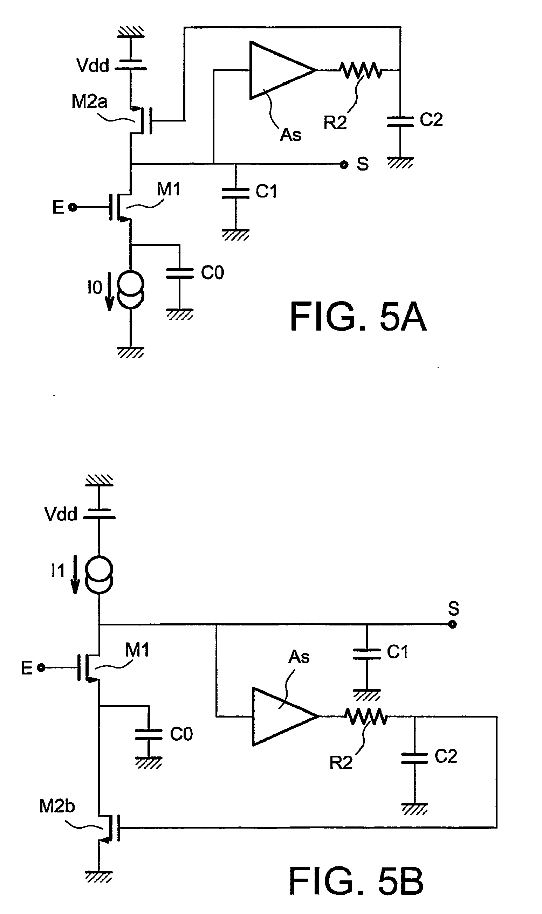

Les figures 4A, 4B, 5A et 5B représentent différentes variantes d'un perfectionnement d'amplificateur tension/tension.

La figure 4A représente une première variante de ce premier perfectionnement.

Selon cette première variante, l'amplificateur comprend tous les éléments déjà décrits en référence à la figure 3 avec, en plus, une résistance R1. La résistance R1 a une première borne connectée au drain du transistor M1 et une deuxième borne connectée à la tension Vdd. Selon d'autres modes de réalisation, la deuxième borne de la résistance R1 peut être connectée à une tension fixe différente de la tension Vdd, comme par exemple la masse.

L'ensemble constitué par la source de courant I1 et la résistance R1 est alors une source de courant non parfaite, de valeur nominale I1, avec une résistance de sortie R1. Par construction, le courant I1 est ici choisi de valeur inférieure à I0. La tension VS se stabilise lorsque la relation suivante est réalisée :

$$Vdd - VS= R1 \times (I0 -I1),$$

soit

$$VS = Vdd - R1 \times (I0 - I1)$$

Dans le cas où la deuxième borne de la résistance R1 est connectée à la masse, par construction le courant I1 est alors choisi supérieur au courant I0. Le courant circulant dans la résistance R1 est alors égal à I1-I0 et les équations qui expriment la tension VS sont modifiées en conséquence.

Le circuit selon la première variante du premier perfectionnement ne passe pas les variations très basse fréquence de la tension d'entrée VE. La tension de sortie revient alors vers son point d'équilibre avec la constante de temps R1C1. Ceci est avantageux, car il est généralement demandé à un amplificateur de tension de circuit de détection de rayons X ou gamma d'être passe-bande (fonction « shaper »).

Si la fréquence de coupure basse est définie par la constante de temps R1C1, la fréquence de coupure haute est, quant à elle, définie par la vitesse de transfert des charges du condensateur de capacité C0 vers le condensateur de capacité C1, c'est-à-dire par la constante de temps $(l/g_m) \times C0$, où $g_m$ est la transconductance du transistor M1, elle-même définie par le choix du courant I0.

L'amplificateur à asservissement représenté en figure 4A régule le courant qui circule dans la résistance R1 de façon que la somme du courant I1 et du courant qui parcourt la résistance R1 soit égale à I0.

La figure 4B représente une deuxième variante du premier perfectionnement.

Selon cette deuxième variante, l'amplificateur comprend tous les éléments déjà décrits en référence à la figure 3 avec, en plus, un transistor MOS TM monté en grille commune et dont la source est connectée à la sortie de l'amplificateur. La grille du transistor TM est alors connectée à une tension fixe VG telle que :

$$VG = VS - VTmos,$$

où VTmos est la tension de seuil du transistor TM et VS la tension de sortie de l'amplificateur.

Le transistor TM, fonctionnant en régime saturé, présente alors un comportement fortement non linéaire en fonction de la tension VS. Un tel montage est particulièrement bien adapté lorsque le signal d'entrée de l'amplificateur est formé d'impulsions.

Le transistor TM peut être de type N ou de type P. Dans le cas où le transistor TM est de type N (figure 4B), son drain est connecté à la tension Vdd et son substrat est à la masse. Le courant I1 est alors inférieur au courant (I0 et le montage est adapté à la présence d'impulsions négatives en entrée de l'amplificateur.

Dans le cas où le transistor TM est de type P (non représenté sur les figures), son drain est connecté à la masse et son substrat est connecté à la tension Vdd. Dans ce cas, le courant I1 est supérieur au courant I0 et le montage est adapté à la présence d'impulsions positives en entrée de l'amplificateur.

Deux autres variantes d'amplificateur à asservissement selon le premier perfectionnement sont représentées aux figures 5A et 5B. Seul le circuit représenté en figure 5A sera décrit, le circuit représenté en figure 5B se déduisant à l'évidence du circuit représenté en figure 5A.

Selon le deuxième exemple d'amplificateur tension/tension à asservissement, l'amplificateur comprend tous les éléments déjà décrits en référence à la figure 3 avec, en plus, un circuit de lecture As et un filtre passe-bas constitué d'une résistance R2 en série avec un condensateur de capacité C2.

Le générateur de courant I1 est ici réalisé par un transistor M2a de type P dont le drain, la source et la grille sont reliés, respectivement, au drain du transistor M1, à la tension d'alimentation Vdd et au point intermédiaire entre R2 et C2. L'entrée du circuit As est reliée aux drains des transistors M1 et M2a (i.e. la sortie S de l'amplificateur). Une première borne du filtre constitué par la résistance R2 en série avec le condensateur de capacité C2 est reliée à la sortie du circuit de lecture As, la deuxième borne du filtre, ou point intermédiaire, étant reliée à la grille du transistor M2a.

La tension de sortie VS est lue par le circuit de lecture As qui reproduit les variations de tension VS avec un gain positif pas nécessairement constant, et avec une tension d'offset pas nécessairement nulle. La sortie du circuit de lecture As est filtrée en basse fréquence par le circuit (R2, C2). La tension filtrée est appliquée à la grille du transistor M2a.

La valeur de repos de la tension VS est celle qui produit sur la grille du transistor M2a, via le circuit de lecture As, une tension telle que le courant I1 qui parcourt le transistor M2a soit égal au courant I0.

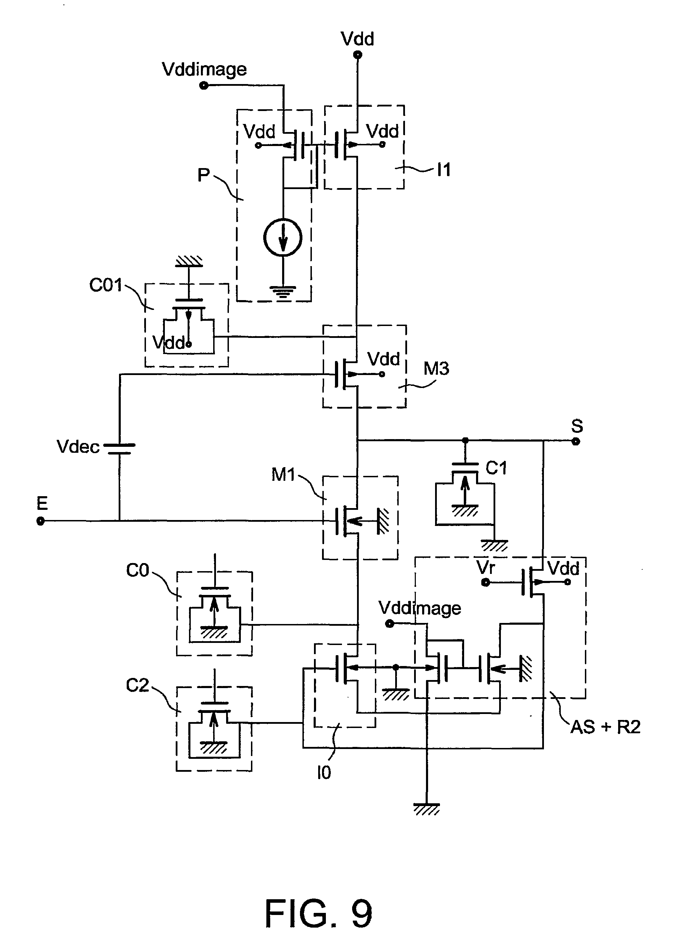

Le circuit de lecture As peut être réalisé de différentes manières. Ainsi, le circuit As peut-il être un suiveur de tension de gain sensiblement égal à l'unité. Le circuit As peut également être un amplificateur différentiel à deux entrées, la tension VS étant appliquée sur une première entrée et une tension de référence étant appliquée sur la deuxième entrée. Dans ce dernier cas, la tension de sortie VS se stabilise à une valeur sensiblement égale à la tension de référence. Un troisième exemple est celui où le circuit As amplifie les variations de la tension VS par rapport à une tension de référence déterminée à partir d'une tension de réglage, comme cela apparaîtra, à titre d'exemple, à la figure 9.

Afin d'assurer la stabilité du montage, le circuit de lecture As est conçu pour introduire un faible déphasage. L'amplificateur selon les deux variantes décrites aux figures 5A et 5B ne passe pas le continu. La fréquence de coupure basse est définie par la constante de temps R2C2. La fréquence de coupure haute est définie, comme précédemment, par $(l/g_m)$ x C0.

Selon le schéma de la figure 5A, le générateur de courant I0 est maître et le générateur de courant I1 est asservi. La figure 5B représente la variante selon laquelle le générateur de courant I1 est maître et le générateur de courant I0, réalisé à l'aide d'un transistor M2b, est asservi.

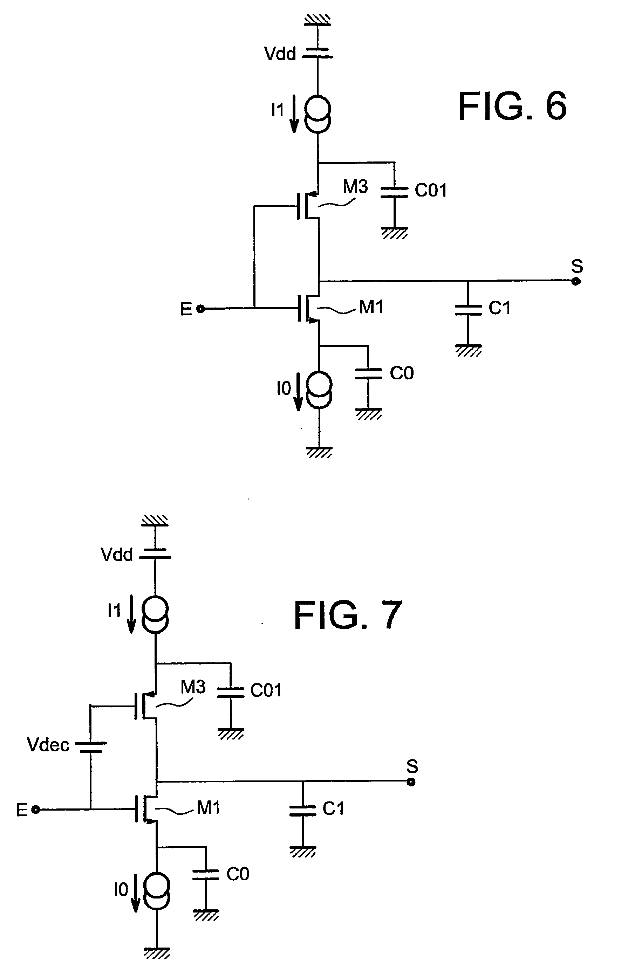

La figure 6 représente un amplificateur tension/tension selon un premier mode de réalisation de l'invention. L'amplificateur de l'invention comprend des moyens pour accroître le gain de l'amplificateur.

L'amplificateur tension/tension selon l'invention comprend tous les éléments déjà décrits en référence à la figure 3 avec, en plus, un transistor M3 et un condensateur de capacité C01. Le transistor M3 est un transistor MOS de type P monté en série entre le transistor M1 et le générateur de courant I1, le drain, la source et la grille du transistor M3 étant reliés, respectivement, au drain du transistor M1, au générateur de courant I1 et à l'entrée E de l'amplificateur. L'entrée E de l'amplificateur est donc reliée aux grilles des transistors M1 et M3. Le condensateur de capacité C01 a une première borne reliée à la source du transistor M3 et une deuxième borne reliée à la masse du circuit.

De même que précédemment, l'égalité précise entre les courants I0 et I1 peut être assurée par un dispositif d'asservissement, lequel n'est pas représenté sur la figure 6 afin de ne pas alourdir le dessin. Le dispositif d'asservissement est alors réalisé, par exemple, par l'un quelconque des dispositifs d'asservissement décrits précédemment (cf. figures 4A-5B).

Les transistors M1 et M3 sont en régime saturé. Il s'en suit que :

$$VS > VE - VT(M1),$$

et

$$VS < VE - VT(M2),$$

où

VT(M1) est la tension de seuil (positive) du transistor M1 et VT(M2) est la tension de seuil (négative) du transistor M2. C'est le rôle du dispositif d'asservissement (non représenté sur la figure 6) que d'assurer une valeur de repos de la tension VS qui respecte précisément ces deux inéquations.

Lorsque la tension d'entrée VE croît, le courant qui parcourt le transistor M1 croît et le courant qui parcourt le transistor M3 diminue.

A la fin d'un transitoire de tension d'entrée ∆VE, il vient :

$$\Delta VS = -(C0/C1+C01/C1) \times \Delta VE$$

Avantageusement, le gain de l'amplificateur est donc accru. Si, par exemple, les capacités C0 et C01 sont sensiblement égales, le gain est doublé alors que la consommation demeure inchangée.

Un deuxième mode de réalisation de l'invention est représentée en figure 7. Cette autre mode s'applique préférentiellement au cas où l'étage amont délivre simultanément une tension de sortie sous la forme de deux tensions de repos différentes. Dans le cas où l'étage amont ne délivre qu'une seule tension de sortie, il est clair, pour l'homme de l'art, qu'une duplication de tension peut se réaliser à l'aide d'un étage intermédiaire, par exemple en utilisant la chute de tension qui apparaît aux bornes d'une diode polarisée en direct. Le schéma de la figure 7 illustre, de façon symbolique, la duplication de la tension de sortie de l'étage amont sous la forme d'une tension de décalage Vdec appliquée entre la grille du transistor M3 et la grille du transistor M1. La tension VE est ainsi appliquée sur la grille du transistor M1 et la tension VE + Vdec sur la grille du transistor M3.

Dans le cas où la tension Vdec est négative, la valeur minimale nécessaire de la tension d'alimentation Vdd est réduite et il est possible, en conséquence, de réduire la puissance dissipée (mais alors l'excursion de la tension VS se trouve également réduite). A l'inverse, dans le cas où la tension Vdec est positive, la valeur minimale de la tension d'alimentation Vdd est augmentée et il est possible, en conséquence, d'augmenter l'excursion de la tension VS (mais alors la puissance dissipée se trouve également augmentée).

Il faut ici noter que les figures 4A, 4B, 5A, 5B décrites précédemment représentent des perfectionnements relatifs à des amplificateurs de tension de l'art connu et que ces perfectionnements, qui consistent à associer un circuit d'asservissement aux amplificateurs de tension, concernent également l'invention et donc les circuits représentés aux figures 6 et 7. C'est pour des raisons de commodité que les amplificateurs de tension de l'invention munis de circuit d'asservissement n'ont pas été représentés sur des figures.

La figure 8 représente une variante du mode de réalisation représenté en figure 6.

En plus des éléments représentés en figure 6, le circuit de la figure 8 comprend un montage cascode constitué de deux transistors MK1 et MK2, respectivement de type P et N, montés en série entre les transistors M3 et M1. La source du transistor MK1 est reliée au drain du transistor M3 et la source du transistor MK2 est reliée au drain du transistor M1. Les drains des transistors Mk1 et MK2 sont reliés entre eux et constituent la sortie de l'amplificateur de tension. Les tensions VK1 et VK2 respectivement appliquées sur la grille du transistor MK1 et sur la grille du transistor MK2 sont ajustées pour assurer la polarisation en mode cascode. Un avantage du circuit représenté en figure 8 est de réduire les capacités Miller du montage et, en conséquence, de réduire la charge vue par l'étage situé en amont.

Le circuit représenté en figure 8 comprend, à titre d'exemple, un montage cascode à deux transistors. L'invention concerne également des circuits dont le montage cascode ne comprend, par exemple, qu'un seul transistor.

La figure 9 représente un circuit électrique en technologie MOS illustrant un exemple de réalisation d'amplificateur selon l'invention. Le circuit électrique de la figure 9 correspond à un amplificateur dont le schéma de principe est celui de la figure 7 et qui comprend un dispositif d'asservissement tel que représenté en figure 5B. Il s'en suit que le circuit électrique illustré en figure 9 comprend les générateurs de courant I1 et I0, les transistors M1 et M3, les condensateurs de capacités respectives C0, C1, C01, C2, l'amplificateur de lecture As et la résistance R2, tous ces composants étant réalisés à l'aide de transistors MOS. Le circuit représenté en figure 9 comprend également un circuit de polarisation P de la grille du transistor qui constitue le générateur de courant I1. Le circuit de polarisation P est alimenté par une tension Vddimage qui est également la tension d'alimentation de l'amplificateur de lecture As. L'amplificateur de lecture As est conforme au troisième exemple d'amplificateur de lecture mentionné précédemment et, en conséquence, amplifie les variations de la tension de sortie VS par rapport à une tension de référence déterminée à partir d'une tension de réglage Vr.

Le circuit électrique représenté en figure 9 est conçu pour amplifier, avec un gain négatif, des impulsions de tension positives qui sont appliquées sur l'entrée E par rapport à un niveau de repos de la tension d'entrée.

Le montage est polarisé entre une tension Vdd et la masse.

**Revendications**

1. Amplificateur de tension comprenant un premier transistor à effet de champ (M1) ayant une grille, un drain et une source, la borne d'entrée et la borne sortie de l'amplificateur étant formées respectivement par la grille et par le drain du premier transistor à effet de champ, l'amplificateur de tension comprenant :

   - un premier générateur de courant (I1) qui charge le drain du premier transistor (M1) ;
   - un deuxième générateur de courant (I0) qui charge la source du premier transistor (M1), la valeur du courant délivré par le deuxième générateur de courant (I0) étant sensiblement égale à la valeur du courant délivré par le premier générateur de courant (I1) ;
   - un premier condensateur (C1) ayant une première borne reliée au drain du premier transistor (M1) et une deuxième borne reliée à une première tension de référence ; et
   - un deuxième condensateur (C0) ayant une première borne reliée à la source du premier transistor (M1) et une deuxième borne reliée à une deuxième tension de référence,

   **caractérisé en ce qu'**il comprend un transistor à effet de champ supplémentaire (M3) de type opposé au premier transistor à effet de champ (M1), le drain du transistor supplémentaire (M3) étant relié au drain du premier transistor à effet de champ (M1), la grille du transistor supplémentaire (M3) étant reliée à une tension décalée ou non décalée par rapport à la tension appliquée sur la grille du premier transistor à effet de champ (M1), la source du transistor à effet de champ supplémentaire étant reliée au premier générateur de courant (I1) et à une première borne d'un condensateur supplémentaire (C01) dont la deuxième borne est reliée à une tension fixe.

2. Amplificateur selon la revendication 1, **caractérisé en ce que**, lorsque la grille du transistor supplémentaire est reliée à une tension décalée par rapport à la tension appliquée sur la grille du premier transistor à effet de champ (M1), il comprend un circuit de décalage de tension pour former la tension appliquée sur la grille du transistor supplémentaire (M3) à partir de la tension appliquée sur la grille du premier transistor à effet de champ (M1).

3. Amplificateur selon la revendication 2, **caractérisé en ce que** le circuit de décalage de tension est une source de tension extérieure.

4. Amplificateur selon la revendication 2, **caractérisé en ce que** le circuit de décalage de tension est une diode polarisée en direct.

5. Amplificateur selon la revendication 1, **caractérisé en ce que**, lorsque la grille du transistor supplémentaire est reliée à une tension non décalée par rapport à la tension appliquée sur la grille du premier transistor à effet de champ (M1), la grille du transistor supplémentaire et la grille du premier transistor à effet de champ sont reliées entre elles.

6. Amplificateur selon l'une quelconque des revendications peécédentes, **caractérisé en ce qu'**il comprend un circuit d'asservissement de la tension de sortie qu'il délivre.

7. Amplificateur selon la revendication 6, **caractérisé en ce que** le circuit d'asservissement est constitué d'une résistance (R1) connectée entre le drain du premier transistor (M1) et une tension fixe.

8. Amplificateur selon la revendication 6, **caractérisé en ce que** le circuit d'asservissement est constitué d'un circuit de lecture (As) dont l'entrée reçoit la tension de sortie (VS) de l'amplificateur et dont la sortie délivre un signal de commande de la grille d'un transistor (M2a, M2b) qui constitue le premier ou le second générateur de courant.

9. Amplificateur selon la revendication 8, **caractérisé en ce qu'**il comprend un filtre passe-bas (R2, C2) placé en sortie du circuit de lecture pour filtrer le signal de commande délivré par le circuit de lecture (As).

10. Amplificateur selon la revendication 8 ou 9, **caractérisé en ce que** le circuit de lecture (As) est un suiveur de tension.

11. Amplificateur selon la revendication 8 ou 9, **caractérisé en ce que** le circuit de lecture (As) est un amplificateur différentiel à deux entrées, la tension de sortie de l'amplificateur étant appliquée sur une première entrée de l'amplificateur différentiel et une tension de référence étant appliquée sur la deuxième entrée de l'amplificateur différentiel.

12. Amplificateur selon la revendication 8 ou 9, **caractérisé en ce que** le circuit de lecture (As) est un amplificateur qui amplifie les variations de la tension de sortie (VS) de l'amplificateur par rapport à une tension de référence déterminée à partir d'une tension de réglage (Vr).

13. Amplificateur selon la revendication 6, **caractérisé en ce que** le circuit d'asservissement est constitué d'un transistor MOS monté en grille commune (TM) et dont la source est connectée à la sortie de l'amplificateur.

14. Amplificateur selon l'une quelconque des revendications précédentes, **caractérisé en ce qu'**il est réalisé en technologie MOS.

15. Détecteur de photons X ou gamma comprenant un amplificateur charge/tension et un amplificateur tension/tension qui amplifie la tension délivrée par l'amplificateur charge/tension, **caractérisé en ce que** l'amplificateur tension/tension est un amplificateur selon l'une quelconque des revendications 1 à 14.

**Claims**

1. Voltage amplifier comprising a first field effect transistor (M1) with a gate, a drain and a source, the amplifier input terminal being the gate of the first field effect transistor, and the amplifier output terminal being the drain of this first field effect transistor, the voltage amplifier comprising:

   - a first current generator (I1) that charges the drain of the first transistor (M1);
   - a second current generator (I0) that charges the source of the first transistor (M1), the value of the current output by the second current generator (I0) being substantially equal to the value of the current output by the first current generator (I1);
   - a first capacitor (C1) with a first terminal connected to the drain of the first transistor (M1) and a second terminal connected to a first reference voltage ; and
   - a second capacitor (C0) with a first terminal connected to the source of the first transistor (M1) and a second terminal connected to a second reference voltage,

   **characterised in that** it comprises an additional field effect transistor (M3) of the type opposite to the type of the first field effect transistor (M1), the drain of the additional transistor (M3) being connected to the drain of the first field effect transistor (M1), the gate of the additional transistor (M3) being connected to a voltage that is or is not offset from the voltage applied to the gate of the first field effect transistor (M1), the source of the additional field effect transistor being connected to the first current generator (I1) and to a first terminal of an additional capacitor (C01) the second terminal of which is connected to a fixed voltage.

2. Amplifier according to claim 1, **characterised in that**, when the gate of the additional transistor is connected to a voltage offset from the voltage applied to the gate of the first field effect transistor (M1), it comprises a voltage offset circuit to form the voltage applied to the gate of the additional transistor (M3) from the voltage applied to the gate of the first field effect transistor (M1).

3. Amplifier according to claim 2, **characterised in that** the voltage offset circuit is an external voltage source.

4. Amplifier according to claim 2, **characterised in that** the voltage offset circuit is a directly polarised diode.

5. Amplifier according to claim 1, **characterised in that**, when the gate of the additional transistor is connected to a voltage not offset from the voltage applied to the gate of the first field effect transistor (M1), the gate of the additional transistor and the gate of the first field effect transistor are connected together.

6. Amplifier according to any one of the previous claims, **characterised in that** it comprises a slaving circuit to control its output voltage.

7. Amplifier according- to claim 6, **characterised in that** the slaving circuit is composed of a resistor (R1) connected between the drain of the first transistor (M1) and a fixed voltage.

8. Amplifier according to claim 6, **characterised in that** the slaving circuit is composed of a read circuit (As) in which the amplifier output voltage (VS) is applied to the input of said read circuit, and a control signal is output by said read circuit to control the gate of a transistor (M2a, M2b) that forms the first or the second current generator.

9. Amplifier according to claim 8, **characterised in that** it comprises a low pass filter (R2, C2) placed at the output from the read circuit to filter the control signal output by the read circuit (As).

10. Amplifier according to claim 8 or 9, **characterised in that** the read circuit (As) is a voltage follower.

11. Amplifier according to claim 8 or 9, **characterised in that** the read circuit (As) is a differential amplifier with two inputs, the amplifier output voltage being applied to a first input of the differential amplifier and a reference voltage being applied to the second input of the differential amplifier.

12. Amplifier according to claim 8 or 9, **characterised in that** the read circuit (As) is an amplifier that amplifies the variations of the amplifier output voltage (VS) compared with a reference voltage determined from an adjustment voltage (Vr).

13. Amplifier according to claim 6, **characterised in that** the slaving circuit is composed of a MOS transistor mounted with common gate (TM) and the source of which is connected to the amplifier output.

14. Amplifier according to any one of the previous claims, **characterised in that** it is made using the MOS technology.

15. X photon or gamma detector comprising a charge/voltage amplifier and a voltage/voltage amplifier that amplifies the voltage output by the charge/voltage amplifier, **characterised in that** the voltage/voltage amplifier is an amplifier according to any one of claims 1 to 14.

**Patentansprüche**

1. Spannungsverstärker mit einem ersten Feldeffekttransistor (M1), ein Gate, einen Drain und eine Source umfassend, wobei der Eingangsanschluss und der Ausgangsanschluss des Verstärkers jeweils durch das Gate und den Drain des ersten Feldeffekttransistors gebildet werden und der Spannungsverstärker dabei umfasst:

   - einen ersten Stromgenerator (I1), der den Drain des ersten Transistors (M1) speist;
   - einen zweiten Stromgenerator (I0), der die Source des ersten Transistors (M1) speist, wobei der durch den zweiten Stromgenerator (IO) gelieferte Strom im Wesentlichen gleich dem Wert des durch den ersten Stromgenerator (I1) gelieferten Stroms ist;
   - einen ersten Kondensator (C1) mit einem ersten Anschluss, verbunden mit dem Drain des ersten Transistors (M1), und einen zweiten Anschluss, verbunden mit einer ersten Bezugsspannung; und
   - einen zweiten Kondensator (C0) mit einem ersten Anschluss, verbunden mit der Source des ersten Transistors (M1), und einen zweiten Anschluss, verbunden mit einer zweiten Bezugsspannung,

   **dadurch gekennzeichnet, dass** er einen zusätzlichen Feldeffekttransistor (M3) des dem ersten Feldeffekttransistor (M1) entgegengesetzten Typs umfasst, wobei der Drain des zusätzlichen Transistors (M3) verbunden ist mit dem Drain des ersten Feldeffekttransistors (M1), das Gate des Zusatztransistors (M3) verbunden ist mit einer Spannung, die verschoben oder nicht verschoben ist in Bezug auf die an das Gate des ersten Feldeffekttransistors (M1) gelegte Spannung, und die Source des zusätzlichen Feldeffekttransistors verbunden ist mit dem ersten Stromgenerator (I1) und mit einem ersten Anschluss eines zusätzlichen Kondensators (C01), dessen zweiter Anschluss mit einer festen Spannung verbunden ist.

2. Verstärker nach Anspruch 1, **dadurch gekennzeichnet, dass** - wenn das Gate des zusätzlichen Transistors verbunden ist mit einer Spannung, die verschoben ist in Bezug auf die an das Gate des ersten Feldeffekttransistors (M1) gelegte Spannung -, er eine Spannungsverschiebungsschaltung umfasst, um aus der an das Gate des ersten Feldeffekttransistors (M1) gelegten Spannung die an das Gate des zusätzlichen Transistors (M3) gelegte Spannung zu formen.

3. Verstärker nach Anspruch 2, **dadurch gekennzeichnet, dass** die Spannungsverschiebungsschaltung eine äußere Spannungsquelle ist.

4. Verstärker nach Anspruch 2, **dadurch gekennzeichnet, dass** die Spannungsverschiebungsschaltung eine direkt polarisierte Diode ist.

5. Verstärker nach Anspruch 1, **dadurch gekennzeichnet, dass** - wenn das Gate des zusätzlichen Transistors mit einer in Bezug auf die an das Gate des ersten Feldeffekttransistors (M1) gelegten Spannung nicht verschoben ist -, das Gate des zusätzlichen Transistors und das Gate des ersten Feldeffekttransistors miteinander verbunden sind.

6. Verstärker nach einem der vorangehenden Ansprüche, **dadurch gekennzeichnet, dass** er eine Regelungsschaltung der Ausgangsspannung umfasst, die er liefert.

7. Verstärker nach Anspruch 6, **dadurch gekennzeichnet, dass** die Regelungsschaltung durch einen zwischen dem Drain des ersten Transistors (M1) und einer festen Spannung geschalteten Widerstand (R1) gebildet wird.

8. Verstärker nach Anspruch 6, **dadurch gekennzeichnet, dass** die Regelungsschaltung durch eine Leseschaltung (As) gebildet wird, deren Eingang die Ausgangsspannung (VS) des Verstärkers erhält und deren Ausgang ein Steuersignal des Gates eines Transistors (M2a, M2b) liefert, der den ersten oder den zweiten Stromgenerator bildet.

9. Verstärker nach Anspruch 8, **dadurch gekennzeichnet, dass** er ein Tiefpassfilter (R2, C2) umfasst, angeordnet am Ausgang der Leseschaltung, um das durch die Leseschaltung (As) gelieferte Signal auszufiltern.

10. Verstärker nach Anspruch 8 oder 9, **dadurch gekennzeichnet, dass** die Leseschaltung (As) ein Spannungsfolger ist.

11. Verstärker nach Anspruch 8 oder 9, **dadurch gekennzeichnet, dass** die Leseschaltung (As) ein Differentialverstärker mit zwei Eingängen ist, wobei die Ausgangsspannung des Verstärkers an einen ersten Eingang des Differentialverstärkers gelegt wird, und eine Bezugsspannung an den zweiten Eingang des Differentialverstärkers gelegt wird.

12. Verstärker nach Anspruch 8 oder 9, **dadurch gekennzeichnet, dass** die Leseschaltung (As) ein Verstärker ist, der die Veränderungen der Ausgangsspannung (VS) des Verstärkers in Bezug auf eine bestimmte Bezugsspannung aufgrund einer Regelungsspannung (Vr) verstärkt.

13. Verstärker nach Anspruch 6, **dadurch gekennzeichnet, dass** die Regelungsschaltung gebildet wird durch einen mit gemeinsamem Gate geschalteten MOS-Transistor (TM), dessen Source mit dem Ausgang des Verstärkers verbunden ist.

14. Verstärker nach einem der vorangehenden Ansprüche, **dadurch gekennzeichnet, dass** er in MOS-Technik realisiert ist.

15. Röntgen- oder Gammaphotonen-Detektor, einen Ladungs-/Spannungsverstärker und einen Spannungs-/Spannungsverstärker umfassend, der die durch den Ladungs-/Spannungsverstärker gelieferte Spannung verstärkt, **dadurch gekennzeichnet, dass** der Spannungs-/Spannungs-Verstärker ein Verstärker nach einem der Ansprüche 1 bis 14 ist.

X, gamma

# FIG. 1

# FIG. 2

FIG. 3

Vdd

I1

E

M1

C1

S

VS

VE

VA

I0

C0

---

Vdd

I1

B

M3

C01

VK1

MK1

VK2

MK2

S

C1

E

M1

FIG. 8

I0

C0

Vdd

I1

R1

S

E

M1

C1

I0

C0

# FIG. 4A

Vdd

TM

V_G

I1

S

E

M1

C1

R1

I0

C0

# FIG. 4B

FIG. 5A

FIG. 5B

Vdd

I1

M3

C01

E

M1

S

C1

I0

C0

# FIG. 6

Vdd

I1

M3

C01

Vdec

E

M1

S

C1

I0

C0

# FIG. 7

FIG. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0789450 A